# EUROPÄISCHE PATENTSCHRIFT

(11) **EP 4 181 171 B1**
(45) Veröffentlichungstag und Bekanntmachung des Hinweises auf die Patenterteilung: **17.07.2024**
(21) Anmeldenummer: 21207969.3
(22) Anmeldetag: 12.11.2021
(51) Int. Cl.: H01L 21/02, H01L 21/306

(54) **VERFAHREN ZUR REINIGUNG EINER HALBLEITERSCHEIBE**
METHOD FOR CLEANING A SEMICONDUCTOR WAFER
PROCÉDÉ DE NETTOYAGE D'UNE PLAQUETTE DE SEMI-CONDUCTEUR

(43) Veröffentlichungstag der Anmeldung: 17.05.2023
(73) Patentinhaber: Siltronic AG, 81677 München (DE)
(72) Erfinder: Kühnstetter, Albert, 84489 Burghausen (DE); Brock, Damian, 84427 Sankt Wolfgang (DE)

(56) Entgegenhaltungen:
- WO-A1-2015/174004
- WO-A1-96/20498
- KR-A- 20100 049 856
- US-A1- 2014 048 100

## Beschreibung

### Stand der Technik

Halbleiterscheiben, die beispielsweise als Substrate für die Herstellung mikroelektronischer Bauelemente dienen, meist Siliciumscheiben, werden nach dem Polieren, Beschichten (beispielsweise durch epitaktische Abscheidung) oder thermischen Behandlungsschritten (engl. "Annealing") bzw. vor Hochtemperaturprozessschritten mit nasschemischen Verfahren gereinigt. Ziel der Reinigung ist es, Kontaminationen der Halbleiterscheiben, beispielsweise mit Metallen wie Kupfer oder mit organischen Substanzen, sowie an der Scheibenoberfläche haftende Partikel möglichst vollständig zu entfernen, da diese Kontaminationen bei der nachfolgenden Herstellung von Bauelementen zu Problemen führen, beispielsweise zu einem inhomogenen Aufwachsen der Gate-Oxide oder zu einem inhomogenen Abscheiden der Polysilicium-Gates.

In Anwendung sind dabei Einzelscheibenreinigungsverfahren, bei denen eine Halbleiterscheibe in eine schnelle Rotation um ihre Mittelachse versetzt wird und dabei zunächst mit einer oder mehreren Flüssigkeiten gereinigt, anschließend mit entionisiertem Wasser gespült und getrocknet wird. Die Flüssigkeiten werden auf die rotierende Halbleiterscheibe aufgebracht und durch die Zentrifugalkraft zum Scheibenrand hin beschleunigt, sodass die Flüssigkeiten nach außen abfließen und dabei auf der Scheibenoberfläche einen in der Regel ganzflächigen, dünnen Film bilden. Bei der anschließenden Trocknung unter weiterer Rotation der Halbleiterscheibe, beispielsweise unter Zugabe eines die Oberflächenspannung des Flüssigkeitsfilms reduzierenden Dampfes (z. B. von Isopropanol) fließt der Flüssigkeitsfilm vollständig nach außen ab. Derartige Verfahren sind beispielsweise in US 2004 10 103 915 A1 und EP 0 905 747 A1 beschrieben.

Aus den Schriften KR 2010 0049856 A, WO 2015/174004 A1, WO 96/20498 A1 sind Verfahren zum Reinigen von Halbleiterscheiben bekannt. H

Aus der Schrift US 2014/048 100 A1 ist ein Verfahren zum Reinigen von Halbleiterscheiben bekannt, bei dem die folgenden Verfahrensschritte verwendet werden:
(1) ein erster Reinigungsschritt zum Reinigen mit ozonisiertem Wasser,
(2) ein zweiter Reinigungsschritt, der einen Behandlungsschritt mit ozonisiertem Wasser enthält, der gefolgt wird von einem Behandlungsschritt mit einer HF enthaltenden Flüssigkeit, wobei der zweite Reinigungsschritt mehrfach wiederholt werden kann,
(3) ein dritter Reinigungsschritt zum Reinigen mit ozonisiertem Wasser,
(4) ein Trocknungsschritt, bei dem die Seite der Halbleiterscheibe getrocknet wird.

Beim Test dieses Verfahrens haben die Erfinder entdeckt, dass Defektmuster auf dem Wafer auftreten können, die mit einer LLS Messung messbar sind. Diese Defekte treten offenbar bevorzugt im Zentrum des Substrates auf und können sich negativ auf das Verhalten der betroffenen Halbleiterscheiben im Fertigungsprozess für Bauelemente auswirken.

Aufgabe der Erfindung ist es daher, ein Verfahren zur Verfügung zu stellen, das diese Defekte nicht hat, oder zumindest die Wahrscheinlichkeit für das Auftreten dieser Defekte minimiert.

Die Aufgabe wird gelöst durch die in den Ansprüchen beschriebenen Verfahren.

### Kurzbeschreibung der Figuren

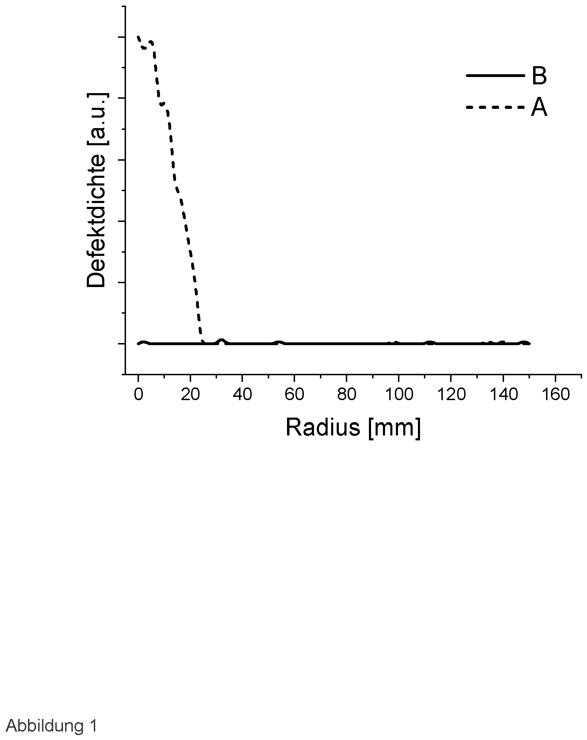

**Abbildung 1** zeigt als Illustration die radiale Defektdichte, die gemessen werden kann, nachdem eine Halbleiterscheibe mit dem nach dem Stand der Technik bekannten Verfahren behandelt wurde (A) und eine andere Halbleiterscheibe, die mit dem erfinderischen Verfahren gereinigt wurde. Deutlich ist zu erkennen, dass das erfinderische Verfahren (B) im Zentrum der Halbleiterscheibe besser Defekte vermeiden mag als das Verfahren nach dem Stand der Technik (A).

### Abkürzungen

| | |
|---|---|
| **DIW** | deionisiertes Wasser. |
| **O3W** | ozonisiertes Wasser bestehend aus 15 - 20 ppm Ozon (Os) gelöst in deionisiertem Wasser. |
| **SC1** | "Standard Clean 1" enthaltend 0,3% Tetramethylammoniumhydroxid (TMAH, [N(CH₃)₄]OH ) und 0,7% Wasserstoffperoxid (H₂O₂) in deionisiertem Wasser. |
| **HF** | 0,5% - 1% Fluorwasserstoff (HF) gelöst in deionisiertem Wasser. |
| **DRY** | Trocknungsprozess, der in 100%-iger Stickstoffatmosphäre (N₂) durchgeführt wird. |

### Detaillierte Beschreibung erfindungsgemäßer Ausführungsbeispiele

Beim Test eines Verfahrens aus dem Stand der Technik zum Reinigen von Halbleiterscheiben mittels einer Vorrichtung zum Reinigen von einzelnen Scheiben ("single wafer cleaner") haben die Erfinder festgestellt, dass Defektmuster auf dem Wafer auftreten können, die mit einer LLS Messung messbar sind.

Diese Defektmuster können durch eine Streulichtmessung (light scattering), beispielsweise mit einem Messgerät von KLA-Tencor unter Verwendung des Surfscan SP1 MX, sichtbar gemacht werden und wird daher auch als Localized Light Scattering-Belastung bezeichnet. WO2005101483 A1 offenbart eine Methode zur Streulichtmessung bei epitaktisch beschichteten Halbleiterscheiben.

Wie **Abbildung 1** zeigt, treten diese Defekte bevorzugt im Zentrum der Halbleiterscheibe auf. Sie können sich negativ auf das Verhalten der betroffenen Halbleiterscheiben im Fertigungsprozess für Bauelemente auswirken.

Bei dem Versuch, diese Defekte nicht auftreten zu lassen, haben die Erfinder entdeckt, dass es vorteilhaft und damit bevorzugt ist, zuerst einen erster Reinigungsschritt zum Reinigen mit ozonisiertem Wasser und anschließendem Spülschritt mit gereinigtem Wasser durchzuführen,
dann einen zweiter Reinigungsschritt, der einen Behandlungsschritt mit ozonisiertem Wasser enthält, der gefolgt wird von einem Behandlungsschritt mit einer HF enthaltenden Flüssigkeit, wobei der zweite Reinigungsschritt mehrfach wiederholt werden kann durchzuführen, dann einen dritten Reinigungsschritt zum Reinigen mit ozonisiertem Wasser und anschließendem Spülschritt mit gereinigtem Wasser durchzuführen, und einen Trocknungsschritt, bei dem die Seite der Halbleiterscheibe getrocknet wird, durchzuführen.

Dabei ist bevorzugt, dass direkt vor dem ersten Reinigungsschritt ein Vorreinigungsschritt mit Wasser erfolgt. Dabei ist essenziell, dass die eine Seite der Halbleiterscheibe, die die Reinigung erfährt, noch nass ist, bevor der erste Reinigungsschritt beginnt.

Die Erfinder haben dabei ferner erkannt, dass es bevorzugt ist, dass während des Vorreinigungsschritts der Anteil von ozonisiertem Wasser von 0% am Anfang des Vorreinigungsschritts auf 100% am Ende des Vorreinigungsschritts gesteigert wird, wobei die Dauer mit einem Anteil kleiner als 5% kleiner ist als 10 s und größer ist als 1 s.

Diese kontinuierliche Erhöhung des Anteils an ozonisiertem Wasser zwischen dem Vorreinigungsschritt hin zum ersten Reinigungsschritt bewirkt offenbar, dass die Anzahl der gefundenen Defekte noch weiter gesenkt wird.

Besonders bevorzugt ist, wenn der Vorreinigungsschritt mindestens 1 s und maximal 15 s dauert, ganz besonders bevorzugt dauert der Schritt mindestens 3 s und maximal 8 s.

Essenziell für das Verfahren ist es, wenn die Seite des Halbleiterscheibe, die gereinigt werden soll, horizontal ausgerichtet ist und während des Vorreinigungsschrittes mit einer Geschwindigkeit von größer als 500 U/min und kleiner als 1000 U/min rotiert. Besonders bevorzugt ist es, wenn zum Auftragen des Wassers im Vorreinigungsschritt eine Düse verwendet wird. Die Düsenströmung beträgt dabei besonders bevorzugt zwischen 0,5 m/s und 2 m/s, wobei der zugehörige Durchfluss bevorzugt zwischen 0,5 l/min und 1,5 l/min beträgt.

Bevorzugt ist es ebenfalls dass die Düse so ausgerichtet ist, dass die Richtung der Düsenströmung mit der Oberfläche der Halb-leiterscheibe einen Winkel α bildet, der kleiner ist als 70° und größer ist als 30°.

Eine ganz besonders bevorzugte Ausprägung des erfinderischen Verfahrens ist in Tabelle 1 gezeigt.

**Tabelle 1**

| **Schritt #** | **Bezeichnung** | **Medium** | **Konzentration** | **Dauer [s]** |
|---|---|---|---|---|
| 0 | DIW | DIW | | 3-8 |
| 1 | O3W | O₃+DIW | 15-20 ppm | 25 |
| 2 | DIW | DIW | | 10 |
| 3 | SC1 | TMAH + H₂O₂ + DIW | TMAH 0,3%, H₂O₂ 0,7% | 20 |
| 4 | DIW | DIW | | 20 |
| 5 | O3W | O₃+DIW | 15-20 ppm | 20 |
| 6 | HF | HF + DIW | 0,5-1% | 3 |
| 7 | O3W | O₃+DIW | 15-20 ppm | 20 |
| 8 | HF | HF + DIW | 0,5-1% | 3 |
| 9 | O3W | O₃+DIW | 15-20 ppm | 20 |
| 10 | HF | HF + DIW | 0,5-1% | 3 |
| 11 | O3W | O₃+DIW | 15-20 ppm | 20 |
| 12 | DIW | DIW | | 10 |
| 13 | DRY | N₂ | | 26 |

## Patentansprüche

1. Verfahren zum Reinigen einer Seite einer Halbleiterscheibe umfassend in gegebener Reihenfolge:
(1) ein erster Reinigungsschritt zum Reinigen mit ozonisiertem Wasser und anschließendem Spülschritt mit gereinigtem Wasser,
(2) ein zweiter Reinigungsschritt, der einen Behandlungsschritt mit ozonisiertem Wasser enthält, der gefolgt wird von einem Behandlungsschritt mit einer HF enthaltenden Flüssigkeit, wobei der zweite Reinigungsschritt mehrfach wiederholt werden kann,
(3) ein dritter Reinigungsschritt zum Reinigen mit ozonisiertem Wasser und anschließendem Spülschritt mit gereinigtem Wasser,
(4) ein Trocknungsschritt, bei dem die Seite der Halbleiterscheibe getrocknet wird,
wobei ein Vorreinigungsschritt mit Wasser direkt vor dem ersten Reinigungsschritt erfolgt, so dass die eine Seite der Halbleiterscheibe noch nass ist, während der erste Reinigungsschritt beginnt.

2. Verfahren nach Anspruch 1, **dadurch gekennzeichnet, dass**
während des Vorreinigungsschritts der Anteil von ozonisiertem Wasser von 0% am Anfang des Vorreinigungsschritts auf 100% am Ende des Vorreinigungsschritts gesteigert wird,
wobei die Dauer mit einem Anteil kleiner als 5% kleiner ist als 10 s und größer ist als 1 s.

3. Verfahren nach Anspruch 1 oder Anspruch 2, **dadurch gekennzeichnet, dass** der Vorreinigungsschritt mindestens 1 s und maximal 15 s dauert.

4. Verfahren nach einem der vorigen Ansprüche, **dadurch gekennzeichnet, dass** die Seite des Halbleiterscheibe horizontal ausgerichtet ist und während des Vorreinigungsschrittes mit einer Geschwindigkeit von größer als 500 U/min und kleiner als 1000 U/min rotiert.

5. Verfahren nach einem der vorigen Ansprüche, **dadurch gekennzeichnet, dass** zum Auftragen des Wassers im Vorreinigungsschritt eine Düse verwendet wird und die Düsenströmung dabei zwischen 0,5 m/s und 2 m/s beträgt, wobei der zugehörige Durchfluss zwischen 0,5 l/min und 1,5 l/min beträgt.

6. Verfahren nach Anspruch 5, **dadurch gekennzeichnet, dass** die Düse so ausgerichtet ist, dass die Richtung der Düsenströmung mit der Oberfläche der Halbleiterscheibe einen Winkel α bildet, der kleiner ist als 70° und größer ist als 30°.

## Claims

1. Process for cleaning a side of a semiconductor wafer, comprising in the order given:
(1) a first cleaning step for cleaning with ozonized water and subsequent rinsing step with purified water,
(2) a second cleaning step, which comprises a treatment step with ozonized water, which is followed by a treatment step with an HF-containing liquid, where the second cleaning step may be repeated multiply,
(3) a third cleaning step for cleaning with ozonized water and subsequent rinsing step with purified water,
(4) a drying step, wherein the side of the semiconductor wafer is dried,
where a preliminary cleaning step with water is effected directly before the first cleaning step, so that the one side of the semiconductor wafer is still wet while the first cleaning step commences.

2. Process according to Claim 1, **characterized in that** during the preliminary cleaning step, the fraction of ozonized water is raised from 0% at the start of the preliminary cleaning step to 100% at the end of the preliminary cleaning step,
the duration with a fraction of less than 5% being less than 10 s and greater than 1 s.

3. Process according to Claim 1 or Claim 2, **characterized in that** the preliminary cleaning step lasts for at least 1 s and not more than 15 s.

4. Process according to any of the preceding claims, **characterized in that** the side of the semiconductor wafer is aligned horizontally and during the preliminary cleaning step rotates at a velocity of greater than 500 rpm and less than 1000 rpm.

5. Process according to any of the preceding claims, **characterized in that** a nozzle is used to apply the water in the preliminary cleaning step and the nozzle flow velocity in this case is between 0.5 m/s and 2 m/s, with the associated flow rate being between 0.5 l/min and 1.5 l/min.

6. Process according to Claim 5, **characterized in that** the nozzle is aligned such that the direction of the nozzle flow forms an angle α with the surface of the semiconductor wafer that is smaller than 70° and larger than 30°.

## Revendications

1. Procédé de nettoyage d'une face d'une plaquette de semiconducteurs comprenant, dans l'ordre indiqué :
(1) une première étape de nettoyage pour le nettoyage avec de l'eau ozonisée, puis une étape de rinçage avec de l'eau purifiée,
(2) une deuxième étape de nettoyage, qui contient une étape de traitement avec de l'eau ozonisée, suivie d'une étape de traitement avec un liquide contenant du HF, la deuxième étape de nettoyage pouvant être plusieurs fois répétée,
(3) une troisième étape de nettoyage pour le nettoyage avec de l'eau ozonisée, suivie d'une étape de rinçage avec de l'eau purifiée,
(4) une étape de séchage, dans laquelle la face de la plaquette de semiconducteurs est séchée,
dans lequel une étape de pré-nettoyage avec de l'eau est réalisée directement avant la première étape de nettoyage, de sorte qu'une face de la plaquette de semiconducteurs est encore humide pendant que commence la première étape de nettoyage.

2. Procédé selon la revendication 1, **caractérisé en ce que**, pendant l'étape de pré-nettoyage, la proportion d'eau ozonisée augmente de 0 % au début de l'étape de pré-nettoyage à 100 % à la fin de l'étape de pré-nettoyage, la durée avec une proportion inférieure à 5 % étant inférieure à 10 secondes et supérieure à 1 seconde.

3. Procédé selon la revendication 1 ou la revendication 2, **caractérisé en ce que** l'étape de pré-nettoyage dure au moins 1 seconde et au maximum 15 secondes.

4. Procédé selon l'une des revendications précédentes, **caractérisé en ce que** la face de la plaquette de semiconducteurs est orientée horizontalement et, pendant l'étape de pré-nettoyage, est mise en rotation à une vitesse supérieure à 500 tr/min et inférieure à 1 000 tr/min.

5. Procédé selon l'une des revendications précédentes, **caractérisé en ce que**, pour appliquer l'eau dans l'étape de pré-nettoyage, on utilise une buse, et la vitesse d'écoulement dans la buse est alors comprise entre 0,5 m/s et 2 m/s, le débit correspondant étant compris entre 0,5 l/min et 1,5 l/min.

6. Procédé selon la revendication 5, **caractérisé en ce que** la buse est orientée de telle sorte que la direction de l'écoulement dans la buse forme avec la surface de la plaquette de semiconducteurs un angle α qui est inférieur à 70° et supérieur à 30°.
